# EUROPÄISCHE PATENTSCHRIFT

(11) **EP 1 589 784 B1**
(45) Veröffentlichungstag und Bekanntmachung des Hinweises auf die Patenterteilung: **12.03.2008**
(21) Anmeldenummer: 05103005.4
(22) Anmeldetag: 15.04.2005
(51) Int. Cl.: H04R 25/02

(54) **Hörhilfegerät mit einer Bedieneinrichtung**
Hearing-aid with operating device
Prothèse auditive avec dispositif de commande

(30) Priorität: 21.04.2004 DE 102004019353
(43) Veröffentlichungstag der Anmeldung: 26.10.2005
(73) Patentinhaber: Siemens Audiologische Technik GmbH, 91058 Erlangen (DE)
(72) Erfinder: Röhrlein, Gerhard, 91315 Höchstadt (DE)
(74) Vertreter: Maier, Daniel Oliver

(56) Entgegenhaltungen:
- EP-A- 1 307 071
- WO-A-00/79769
- WO-A-98/54928
- US-A- 5 553 152

## Beschreibung

Die Erfindung betrifft ein Hörhilfegerät mit wenigstens einer Bedieneinrichtung.

Durch den Fortschritt in der Halbleiterbauelemente-Technik ist es möglich, Hörhilfegeräte immer weiter zu miniaturisieren. Dabei stellt sich jedoch das Problem, dass durch die kleiner werdenden Gehäuse immer weniger Platz für Bedienelemente zur Verfügung steht. Es werden daher zur Bedienung von Hörhilfegeräten häufig Fernbedienungen verwendet. Diese haben jedoch den Nachteil, dass sie stets zusätzlich zu den Hörhilfegeräten mitgeführt werden müssen.

Aus der US 2002/0068537 A1 ist ein Mobiltelefon mit einem Sensor (Proximity-Sensor) bekannt. Dieser Sensor misst den Abstand zwischen dem Telefon und dem Kopf des Benutzers. Mit dem Sensorausgangssignal kann die Verstärkung des Lautsprechers oder des Mikrophons in Abhängigkeit von diesem Abstand gesteuert werden.

Aus der US 5,341,433 ist ein Hörgerät bekannt, bei dem als Bedienelement ein Druck- oder Positionssensor in Film-Auslegung vorhanden ist. Der Sensor ist auf der Außenseite des Gehäuses angebracht und reagiert bereits auf leichte Berührung. Der Sensor-Schalter hat den Nachteil, dass er verhältnismäßig viel Platz auf der Außenseite des Gehäuses beansprucht und zum Auslösen einer Schaltfunktion direkt berührt werden muss.

Aus der DE 31 09 049 A1 ist ein Hörgerät bekannt, welches zum Durchführen von Bedienfunktionen Schalter aufweist. Weiterhin sind bei dem bekannten Hörgerät magnetische Schalter vorgesehen, die mit Magnetfeldern in ihrer elektrischen Leitfähigkeit beeinflussbare Elemente, z.B. Reed-Kontakte oder Magnetfeld-Halbleiter, aufweisen. So kann durch Verschieben eines Magnetes manuell eine Schaltfunktion ausgelöst werden. Die magnetisch betätigbaren Schalter können aber auch dazu dienen, beim Heranführen eines außerhalb des Geräts vorhandenen Magnetfeldes, etwa desjenigen eines Telefonhörers, im Gerät eine Zusatzeinrichtung, etwa eine solche zur Verbesserung der

Aufnahme eines Telefongespräches (Induktionsspule), selbsttätig einzuschalten.

Nachteilig bei dem bekannten Hörgerät ist, dass, ähnlich wie bei der Verwendung einer Fernbedienung, auch hier zusätzliche Mittel (Magnete) vorhanden sein müssen, um eine Schaltfunktion auszulösen.

Aufgabe der Erfindung ist es daher, die direkte Bedienung eines Hörhilfegerätes von Hand zu verbessern.

Diese Aufgabe wird durch ein Hörhilfegerät mit den Merkmalen gemäß Anspruch 1 gelöst.

Die Erfindung bietet den Vorteil, dass zum Auslösen einer Bedienfunktion kein Bedienelement am Hörhilfegerät direkt berührt werden muss. Weiterhin ist es auch nicht erforderlich, eine Fernbedienung oder weitere technische Hilfsmittel (Magnete) mitzuführen. Eine Schaltfunktion wird bereits dadurch ausgelöst, dass der Hörhilfegeräteträger eine Hand und insbesondere einen oder mehrere Finger der Hand in die Nähe des Hörhilfegerätes bringt. Der bei dem Hörhilfegerät vorhandene Näherungssensor erkennt dies und führt daraufhin die mit dem Näherungssensor verbundene Schaltfunktion aus. Dabei kann sowohl das Eintreten der Hand in den Erfassungsbereich des Näherungssensors die Schaltfunktion auslösen als auch das Austreten der Hand aus dem Erfassungsbereich.

Um Fehlschaltungen zu vermeiden, ist bei einer Ausführungsform der Erfindung vorgesehen, dass eine bestimmte zeitliche Abfolge des Ein- bzw. Austretens der Hand in den Erfassungsbereich bzw. aus dem Erfassungsbereich eingehalten werden muss, damit eine Schaltfunktion ausgelöst wird. Z.B. wird eine Schaltfunktion nur dann ausgelöst, wenn die Hand nach dem Eintreten in den Erfassungsbereich innerhalb eines Zeitraums von 2 bis 3 sec wieder aus dem Erfassungsbereich austritt. Eine weitere Ausführungsform der Erfindung sieht vor, dass eine bestimmte zeitliche Abfolge eines mehrmaligen Ein-und/oder Austretens erfolgen muss, damit die betreffende Bedienfunktion ausgelöst wird. Beispielsweise wird eine Schaltfunktion nur dann ausgelöst, wenn die Hand des Hörhilfegeräteträgers innerhalb von 5 sec dreimal in den Erfassungsbereich des Näherungssensors ein- und wieder austritt. Ein unbeabsichtigtes Schalten wird dadurch weitgehend ausgeschlossen.

Die oben genannten Zeiten sind vorzugsweise durch Programmieren des Hörhilfegerätes einstellbar. Insbesondere ist dadurch auch eine Anpassung an die Wünsche des Hörhilfegeräteträgers bezüglich der eingestellten Zeiten und Schaltmuster möglich.

Die durch den Näherungssensor ausgeführte Bedienfunktion betrifft vorzugsweise die Einstellung des aktiven Hörprogramms oder die Lautstärkeregelung. Beispielsweise kann so bei jeder ordnungsgemäß ausgeführten Schaltfunktion die Programmzahl (z.B. Hörprogramm 3) um eins erhöht werden, bis das Hörprogramm mit der höchsten Programmzahl eingestellt ist. Eine weitere Schaltfunktion führt dann zur Einstellung des Hörprogramms mit der niedrigsten Programmzahl (Hörprogramm 1).

Eine andere Variante der Erfindung sieht vor, dass durch unterschiedliche zeitliche Abfolgen des Ein- und Austretens der Hand in bzw. aus dem Erfassungsbereich des Näherungssensors bei ein und demselben Hörhilfegerät verschiedene Bedienfunktionen ausgelöst werden. Z.B. kann bei zweimaligem Ein- und Austreten der Hand innerhalb eines bestimmten Zeitraums die Programmzahl um eins erniedrigt und bei dreimaligem Ein- und Austreten die Programmzahl gegenüber dem ursprünglich eingestellten Hörprogramm um eins erhöht werden.

Insbesondere bei der Lautstärkeregelung wird vorteilhaft nicht nur das Ein- oder Austreten der Hand in bzw. aus dem Erfassungsbereich registriert, sondern auch der Abstand und insbesondere eine Veränderung des Abstandes der Hand von dem Näherungssensor während des Umschaltvorganges. Dann wird durch ein bestimmtes Schaltmuster, d.h. eine bestimmte zeitliche Abfolge des Ein- bzw. Austretens der Hand, nicht sogleich eine Schaltfunktion ausgeführt, sondern das Hörhilfegerät zunächst in einen Zustand überführt, in dem Veränderungen des Abstandes der Hand des Hörhilfegeräteträgers zu dem Näherungssensor erkannt werden. So kann beispielsweise eine Erhöhung des Abstandes eine Erhöhung der eingestellten Lautstärke bewirken. Umgekehrt wird die Lautstärke reduziert, wenn die Hand näher an das Hörhilfegerät herangeführt wird. Analog kann auch die Programmumschaltung, ausgehend von einem bestimmten Hörprogramm, zu einem höheren bzw. niedrigeren Hörprogramm durch eine entsprechende Auswertung der Veränderung des Abstandes durchgeführt werden.

Bei einer gemäß der Erfindung ausgeführten Schaltfunktion kann der Hörhilfegeräteträger vorteilhaft ein wahrnehmbares Signal erhalten zur Bestätigung einer korrekt durchgeführten Bedienung des Hörhilfegerätes in Verbindung mit dem Näherungssensor. Beispielsweise werden nach einer Programmumschaltung Beep-Töne erzeugt und dem Gehör des Hörhilfegeräteträgers zugeführt, deren Anzahl die Programmzahl des nun aktiven Hörprogramms erkennen lassen. Insbesondere bei der oben beschriebenen Bedienung in mehreren Schritten, bei der das zu bedienende Hörhilfegerät im ersten Schritt zunächst in einen Zustand versetzt wird, von dem ausgehend in einem zweiten Schritt eine Veränderung des Abstandes der auslösenden Hand registriert wird, kann vorteilhaft auch bereits der von dem Hörhilfegerät erkannte erste Schritt durch ein akustisches Signal (z.B. einmaliger kurzer Beep) angezeigt werden, auch wenn damit noch keine Veränderung eines die Signalverarbeitung im Hörhilfegerät betreffenden Parameters verbunden ist.

Um unbeabsichtigte Schaltfunktionen zu verhindern, ist der Erfassungsbereich des verwendeten Näherungssensors verhältnismäßig eng begrenzt. Vorzugsweise wird eine Schaltfunktion nur dann ausgelöst, wenn sich die Hand in einem Abstand von wenigen Zentimetern zum Näherungssensor befindet. Nur in Ausnahmefällen wird bei einem Abstand der Hand von mehr als 10 cm noch eine Schaltfunktion ausgeführt. Bei einer bevorzugten Ausführungsform der Erfindung kann der Erfassungsbereich des Näherungssensors bei der Programmierung des Hörhilfegerätes eingestellt und damit an die Bedürfnisse des Hörhilfegeräteträgers angepasst werden.

Eine Ausführungsform der Erfindung sieht vor, dass in Abhängigkeit des Abstandes, in dem die Hand vor den Näherungssensor geführt wird, unterschiedliche Schaltfunktionen ausgeführt werden. Beispielsweise wird bei einer sehr dicht am Ohr vor den Näherungssensor geführten Hand eine erste Schaltfunktion ausgelöst und bei einer in relativ großem Abstand zu dem Ohr (z.B. mehr als 10 cm) vor den Näherungssensor geführter Hand eine zweite, von der ersten Schaltfunktion verschiedene Schaltfunktion ausgelöst.

Eine weitere Ausführungsform der Erfindung sieht die Verwendung mehrerer Näherungssensoren bei einem Hörhilfegerät vor, die sich hinsichtlich ihres Erfassungsbereiches relativ zum Hörhilfegerät unterscheiden. So kann ein erster Näherungssensor auf eine sehr nah an das Hörhilfegerät (z.B. in einen Abstand von weniger als 3 cm) herangeführte Hand reagieren und eine Schaltfunktion auslösen, während ein zweiter Näherungssensor auf eine in größerem Abstand (z.B. größer 8 cm) herangeführte Hand reagiert und eine zweite Schaltfunktion auslöst. Die Erfassungsbereiche der Näherungssensoren bezüglich des Hörhilfegerätes können sich nicht nur hinsichtlich des Abstandes, sondern auch bezüglich der Ausrichtung unterscheiden. So kann ein erster Erfassungsbereich in Blickrichtung und ein zweiter Erfassungsbereich in entgegengesetzte Richtung ausgerichtet sein.

Es können auch mehrere Näherungssensoren verwendet werden, um Fehlschaltungen zu vermeiden. So wird beispielsweise bei einem Hörhilfegerät mit zwei Näherungssensoren nur dann eine Schaltfunktion ausgelöst, wenn die Hand zunächst von dem ersten Näherungssensor erfasst wird, anschließend von den beiden Näherungssensoren erfasst wird, anschließend nur wieder von dem ersten Näherungssensor erfasst wird und schließlich von keinem der beiden Näherungssensoren mehr erfasst wird, wobei sich der gesamte Vorgang innerhalb kurzer Zeit (z.B. 2 sec) ereignen muss. Es kann damit allgemein auf einfache Weise festgelegt werden, aus welcher Richtung die Hand an das Hörhilfegerät herangeführt werden muss und in welche Richtung sie wieder entfernt werden muss, um eine bestimmte Schaltfunktion auszulösen. Ein unbeabsichtigtes Auslösen einer Schaltfunktion wird so weitgehend ausgeschlossen.

Bei CIC-Hörhilfegeräten wird der Abstand der Hand zum Näherungssensor vorzugsweise so eingestellt, dass nur bei einem sehr geringen Abstand eine Schaltfunktion ausgelöst wird. Beispielsweise wird nur dann eine Schaltfunktion ausgelöst, wenn man mit einem Finger direkt in die Concha des betreffenden Ohres greift und damit gewissermaßen den Gehörgangseingang abdeckt. Ein unbeabsichtigtes Umschalten wird dadurch weitgehend ausgeschlossen.

Der im Zusammenhang mit der Erfindung verwendete Näherungssensor ist nicht auf ein bestimmtes Funktionsprinzip beschränkt. Alle gängigen Näherungssensoren, die eine entsprechende Miniaturisierung zulassen, können im Zusammenhang mit der Erfindung verwendet werden, so z.B. Infrarot-Näherungssensoren, Ultraschall-Näherungssensoren, induktive Näherungssensoren oder kapazitive Näherungssensoren.

Die Erfindung ist nicht auf eine bestimmte Schaltfunktion beschränkt. Vielmehr können prinzipiell alle bei Hörhilfegeräten ausführbaren Schaltfunktionen auch in Verbindung mit dem Näherungssensor gemäß der Erfindung ausgeführt werden. Ferner ist es möglich, dass durch Programmierung des Hörhilfegerätes festgelegt wird, welche Schaltfunktion in Verbindung mit dem Näherungssensor ausgeführt wird. Es ist auch möglich, dass bei einer binauralen Versorgung bei dem am oder im linken Ohr getragenen Hörhilfegerät eine andere Schaltfunktion ausgelöst wird, als bei dem am oder im rechten Ohr getragenen Hörhilfegerät. Vorzugsweise wirkt dann die jeweils ausgeführte Schaltfunktion durch eine Kopplung der beiden Hörhilfegeräte auf beide Hörhilfegeräte.

Die Erfindung wird nachfolgend anhand von Ausführungsbeispielen erläutert. Es zeigen:
Figur 1 ein im Ohr tragbares Hörhilfegerät mit einem Näherungsschalter im Blockschaltbild,
Figur 2 ein Ohr mit einem im Ohr tragbaren Hörhilfegerät bei einer Seitenansicht des Kopfes und
Figur 3 einen Längsschnitt durch den äußeren Gehörgang, in dem sich ein im Ohr tragbares Hörhilfegerät gemäß der Erfindung befindet.

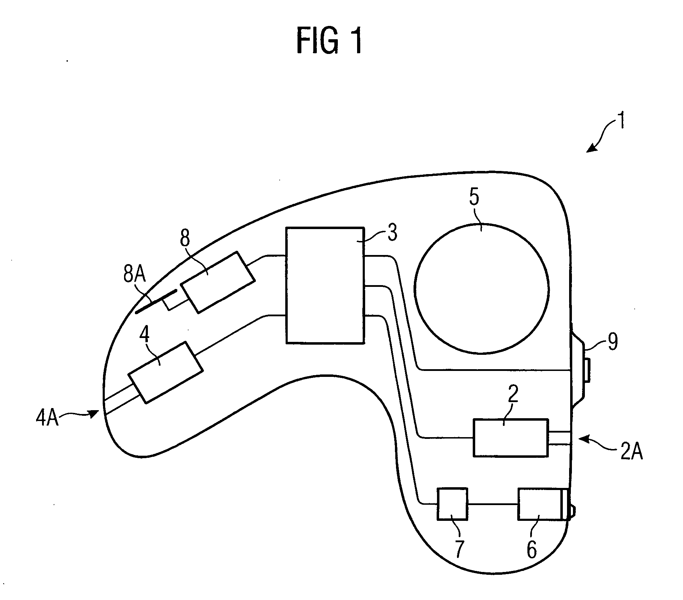

Figur 1 zeigt ein im Ohr tragbares Hörhilfegerät 1 mit seinen wesentlichen Komponenten. Es sind dies ein Mikrofon 2 mit einer Schalleintrittsöffnung 2A zur Aufnahme eines akustischen Signals und Wandlung in ein elektrisches Signal. Das elektrische Signal wird zur Weiterverarbeitung und frequenzabhängigen Verstärkung einer Signalverarbeitungseinheit 3 zugeführt. Schließlich wird das weiterverarbeitete und verstärkte Signal mittels eines Hörers 4 von einem elektrischen Signal in ein akustisches Signal zurückgewandelt und über den Schallkanal 4A in den Gehörgang eines Hörhilfegeräteträgers abgegeben. Zur Spannungsversorgung der elektrischen Komponenten des Hörhilfegerätes 1 dient eine Batterie 5.

Das Hörhilfegerät 1 gemäß dem Ausführungsbeispiel ist in seinen Übertragungseigenschaften an unterschiedliche Hörsituationen (z.B. "ruhige Umgebung", "Gespräch", "Gespräch in störungsbehafteter Umgebung", "Fahrt im Auto" usw.) anpassbar. Die Auswahl erfolgt durch Einstellung bestimmter Parametersätze (Hörprogramme), die die Signalverarbeitung an die jeweilige Hörsituation anpassen. Zwischen den einzelnen Hörprogrammen wird durch Bedienung des Hörhilfegerätes 1 umgeschaltet. Bei dem Hörhilfegerät 1 gemäß der Erfindung folgt die Bedienung zur Programmumschaltung mittels eines Näherungssensors 6. Dieser registriert das Ein- und Austreten eines Objekts in seinen Erfassungsbereich. Um ein unbeabsichtigtes Umschalten zu vermeiden, ist dem Näherungssensor 6 eine Auswerteeinheit 7 zugeordnet. In dieser können durch Programmierung des Hörhilfegerätes 1 bestimmte Schaltmuster festgelegt werden, die zum Ausführen einer bestimmten Schaltfunktion eingehalten werden müssen. Das Hörhilfegerät 1 gemäß der Erfindung kann z.B. so eingestellt sein, dass das auslösende Objekt, vorzugsweise die Hand des Hörhilfegeräteträgers, dreimal in einem Zeitraum von ca. 3 sec in den Erfassungsbereich des Näherungssensors 6 gebracht und wieder daraus entfernt werden muss. Wurde ein derartiges Schaltmuster erkannt, so kann bei dem Hörhilfegerät 1 kurzzeitig eine Programmumschaltung vorgenommen werden. Hierzu muss die Hand erneut in den Erfassungsbereich des Näherungssensors 6 gebracht werden, wobei nun auch die Entfernung der Hand zu dem Näherungssensor 6 bestimmt wird. Eine Verringerung des Abstandes bewirkt dann ein Umschalten zu einem Hörprogramm mit einer niedrigeren Programmzahl, z.B. von Hörprogramm 4 auf Hörprogramm 3. Wird hingegen der Abstand vergrößert, so führt dies zum Umschalten in ein Hörprogramm mit einer höheren Programmzahl, z.B. von Hörprogramm 4 auf Hörprogramm 5.

Das Hörhilfegerät 1 gemäß dem Ausführungsbeispiel umfasst als weitere Komponente eine Sende- und Empfangseinheit 8 mit einer Antenne 8A zum drahtlosen Datenaustausch mit einem weiteren Hörhilfegerät zur binauralen Versorgung eines Hörhilfegeräteträgers. Im Ausführungsbeispiel wird dadurch eine in der geschilderten Weise hervorgerufene Programmumschaltung auch auf das zweite Hörhilfegerät übertragen, welches dadurch die gleiche Programmumschaltung durchführt. Im Gegenzug kann bei dem zweiten Hörhilfegerät gleicher Bauart mittels eines dem Näherungssensor 6 entsprechenden Näherungssensors in analoger Weise eine Veränderung der Lautstärkeeinstellung erfolgen, die dann über die Antenne 8A und die Sende- und Empfangseinheit auf das Hörhilfegerät 1 übertragen wird und dort eine analoge Lautstärkenänderung bewirkt.

Als weitere Komponente ist bei dem Hörhilfegerät 1 gemäß dem Ausführungsbeispiel auch ein Tastschalter 9 vorhanden, durch den mittels direkter Berührung ebenfalls eine Schaltfunktion ausgelöst werden kann. Z.B. kann es sich bei dieser Schaltfunktion um das Ein- bzw. Ausschalten eines Algorithmus zur Störgeräuschbefreiung handeln. Durch die Betätigung des Tastschalters 9 ist eine Bedienung mittels des Näherungssensors 6 kurzzeitig nicht möglich. Dadurch wird gewährleistet, dass bei einer Betätigung des Tastschalters 9, die ja zwangsläufig mit dem Eindringen der Hand in den Erfassungsbereich des Näherungssensors 6 verbunden ist, unbeabsichtigte Schaltvorgänge durch den Näherungssensor 6 unterbunden werden.

Durch die Verwendung des Näherungssensors 6 kann bei dem Hörhilfegerät 1 gemäß dem Ausführungsbeispiel eine Schaltfunktion ohne direkte Berührung eines Bedienelements ausgeführt werden. Es sind auch keine technischen Hilfsmittel (Fernbedienung, Magnete usw.) erforderlich, die mit dem Hörhilfegerät mitgeführt werden müssten. Die Erfindung ist daher besonders bei im Ohr tragbaren Hörhilfegeräten und insbesondere Ohrkanalgeräten vorteilhaft, da bei diesen kaum Platz zur Anbringung herkömmlicher Bedienelemente vorhanden ist und weiterhin übliche Bedienelemente auch nur schwer zugänglich sind. Dennoch ist die Erfindung nicht auf im Ohr tragbare Hörhilfegeräte beschränkt, sondern prinzipiell bei allen bekannten Hörhilfegeräte-Bauarten anwendbar.

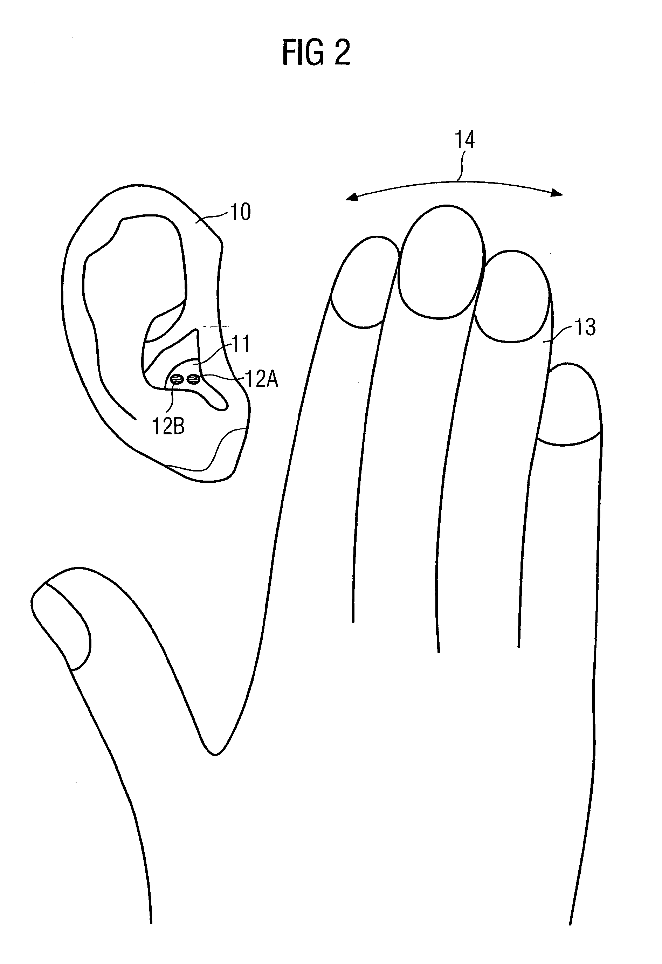

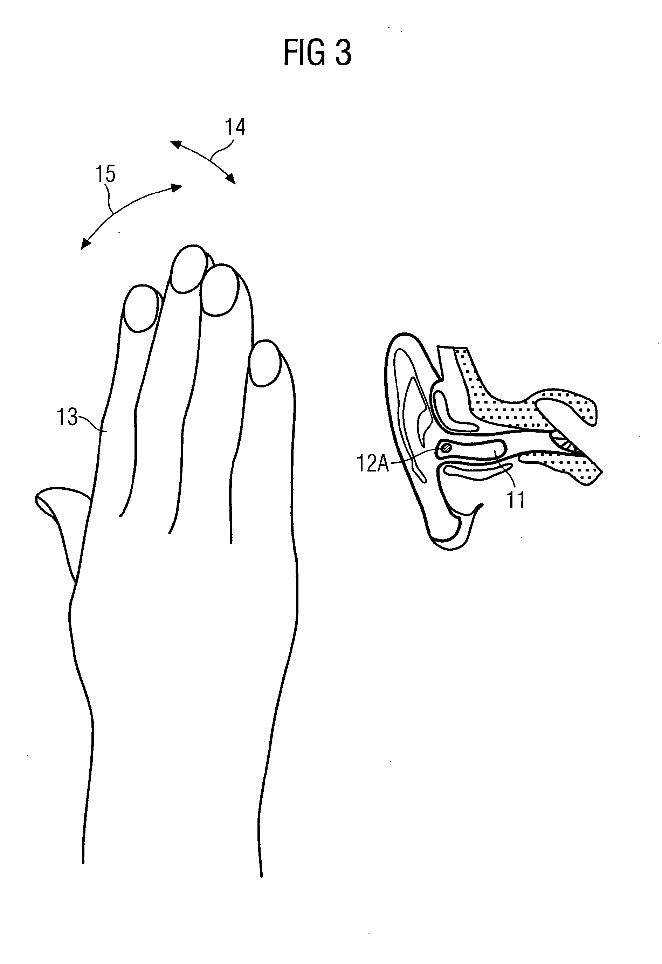

Mittels der Figuren 2 und 3 soll nochmals das Auslösen eines Schaltvorgangs bei einem Hörhilfegerät gemäß der Erfindung verdeutlicht werden. Figur 2 zeigt hierzu eine Ohrmuschel 10 bei einer Seitenansicht des Kopfes. In der Ohrmuschel 10 befindet sich ein im Ohr tragbares Hörhilfegerät 11, welches zum überwiegenden Teil in den Gehörgang (nicht dargestellt) hineinragt. Das Hörhilfegerät 11 gemäß dem Ausführungsbeispiel umfasst zwei in einem Abstand zueinander angeordnete Näherungssensoren 12A und 12B. Wird nun die Hand 13 des Hörhilfegeräteträgers in einem bestimmten, vordefinierten Rhythmus dicht an das Hörhilfegerät 11 herangeführt und wieder davon entfernt, wie dies durch den Doppelfeil 14 angedeutet ist, so wird dadurch eine Bedienfunktion ausgelöst.

Um Fehlschaltungen zu vermeiden, wird bei dem Hörhilfegerät 11 jedoch immer nur dann eine Schaltfunktion ausgelöst, wenn die Hand zunächst von dem Näherungssensor 12A erfasst wird, anschließend von beiden Näherungssensoren 12A und 12B erfasst wird, anschließend wieder nur von dem Näherungssensor 12A erfasst wird und anschließend von keinem der beiden Näherungssensoren mehr erfasst wird. Eine Schaltfunktion wird damit im Ausführungsbeispiel nur dann ausgelöst, wenn die Hand von vorne (aus Richtung der Vorderseite des Kopfes) vor das Ohr geführt und wieder nach vorne entfernt wird. Weiterhin wird die betreffende Schaltfunktion nur dann ausgelöst, wenn das auslösende Bewegungsmuster innerhalb kurzer Zeit, z.B. innerhalb 2 sec, ausgeführt wird.

Selbstverständlich können mittels der beiden Näherungssensoren 12A und 12B und einer damit verbundenen Steuerung auch andere Bewegungsmuster vorgegeben werden, die zum Auslösen einer Schaltfunktion mit der Hand ausgeführt werden müssen. Beispielsweise wird bei einer anderen Programmierung des Hörhilfegerätes 11 nur dann eine Schaltfunktion ausgelöst, wenn die Hand 13 zunächst von vorne nach hinten am Ohr vorbeigeführt wird (bis sie wieder außerhalb der Erfassungsbereiche beider Näherungssensoren 12A, 12B liegt) und anschließend wieder von hinten nach vorne am Ohr vorbeigeführt wird.

Zum Ausführen unterschiedlicher Schaltfunktionen (Programmzahl erhöhen, Programmzahl verringern, Lautstärke erhöhen, Lautstärke verringern, Filter einschalten usw.) können unterschiedliche Bewegungsmuster vorgegeben werden, die zum Ausführen der jeweiligen Schaltfunktion eingehalten werden müssen.

Weiterhin können die Erfassungsbereiche der beiden Näherungssensoren auch unterschiedlich ausgerichtet sein, so dass der Erfassungsbereich des Näherungssensors 12A seitlich noch vorne gerichtet ist, während der Erfassungsbereich des Näherungssensors 12B seitlich nach hinten gerichtet ist. Dann kann eine von vorn an das Ohr geführte Hand eine andere Schaltfunktion auslösen als eine von hinten an das Ohr geführte Hand.

Figur 3 zeigt den äußeren Gehörgang mit dem darin befindlichen Hörhilfegerät 11 im Längsschnitt. Figur 3 verdeutlicht, dass neben einer Bewegung der Hand 13 in Richtung des Doppelpfeiles 14 auch eine Bewegung in Richtung des Doppelpfeiles 15, also zum Ohr hin oder davon weg, möglich ist. Wie bei dem Ausführungsbeispiel gemäß Figur 1 beschrieben, kann dadurch das Hörhilfegerät 11 mit den Näherungssensoren 12A und 12B (verdeckt) zunächst in einen Modus überführt werden, in dem dann der Abstand der Hand 13 zu den Näherungssensoren und insbesondere eine Veränderung dieses Abstandes ausgewertet wird. Dadurch lassen sich, wie in den Ausführungen zu Figur 1 beschrieben, auch komplexere Schaltfunktionen (z.B. Lautstärkeregelung) durchführen.

Die Erfindung bietet weiterhin die Möglichkeit, dass in Abhängigkeit des Abstandes, in dem die Hand 13 vor die Näherungssensoren 12A und 12B geführt wird, unterschiedliche Schaltfunktionen ausgeführt werden. Beispielsweise wird bei einer sehr dicht am Ohr vor die Näherungssensoren geführten Hand 13 eine Programmumschaltung vorgenommen und bei einer in relativ großem Abstand zu dem Ohr (z.B. mehr als 10 cm) vor die Näherungssensoren 12A und 12B geführten Hand 13 ein Algorithmus zur Rückkopplungsunterdrückung ein- bzw. ausgeschaltet.

## Patentansprüche

1. Hörhilfegerät (1; 11) mit einer Bedieneinrichtung, **dadurch gekennzeichnet, dass** die Bedieneinrichtung wenigstens einen Näherungssensor (6; 12A, 12B) umfasst, der beim Ein- oder Austreten einer Hand (13) eines Hörhilfegeräteträgers in den Erfassungsbereich bzw. aus dem Erfassungsbereich des Näherungssensors (6; 12A, 12B) eine Bedienfunktion auslöst.

2. Hörhilfegerät nach Anspruch 1, wobei lediglich eine bestimmte zeitliche Abfolge eines mehrmaligen Ein- und/oder Austretens der Hand (13) in den Erfassungsbereich bzw. aus dem Erfassungsbereich die Bedienfunktion auslöst.

3. Hörhilfegerät nach Anspruch 1 oder 2, wobei unterschiedliche zeitliche Abfolgen des Ein- und/oder Austretens der Hand (13) in den Erfassungsbereich bzw. aus dem Erfassungsbereich verschiedene Bedienfunktionen auslösen.

4. Hörhilfegerät nach einem der Ansprüche 1 bis 3, wobei die Bedienfunktion die Einstellung des aktiven Hörprogramms oder die Lautstärkeregelung betrifft.

5. Hörhilfegerät nach einem der Ansprüche 1 bis 4, wobei die Bedienfunktion unter Berücksichtigung des Abstandes der Hand (13) von dem Näherungssensor (6; 12A, 12B) und insbesondere unter Berücksichtigung einer Veränderung dieses Abstandes erfolgt.

6. Hörhilfegerät nach einem der Ansprüche 1 bis 5, wobei der Erfassungsbereich auf einen Abstand von 0 bis 10 cm zum Näherungssensor (6; 12A, 12B) begrenzt ist.

7. Hörhilfegerät nach einem der Ansprüche 1 bis 6, wobei der Näherungssensor (6; 12A, 12B) als Infrarot-Näherungssensor, Ultraschall-Näherungssensor, induktiver Näherungssensor oder kapazitiver Näherungssensor ausgeführt ist.

8. Hörhilfegerät nach einem der Ansprüche 1 bis 7, wobei die Bedienfunktion nur dann ausgelöst wird, wenn nicht unmittelbar nach dem Eintreten der Hand (13) in den Erfassungsbereich des Näherungssensors (6; 12A, 12B) ein durch direkte Berührung von Hand betätigbares Bedienelement (9) des Hörhilfegerätes (1) betätigt wird.

9. Hörhilfegerät nach einem der Ansprüche 1 bis 8, wobei mehrere Näherungssensoren (12A, 12B) mit unterschiedlichen Erfassungsbereichen relativ zu dem Hörhilfegerät (11) vorhanden sind.

10. Hörhilfegerät nach einem der Ansprüche 1 bis 9, ausgebildet als im Ohr tragbares und insbesondere als komplett im Gehörgang tragbares Hörhilfegerät.

## Claims

1. Hearing aid (1; 11) with an operating device, **characterised in that** the operating device includes at least one proximity sensor (6; 12A, 12B) which initiates an operating function when a hand (13) of a hearing aid wearer is moved into or out of the detection area of the proximity sensor (6; 12A, 12B).

2. Hearing aid according to claim 1, where only a specific chronological sequence of multiple entry and/or exit of the hand (13) into the detection area of out of the detection area initiates the operating function.

3. Hearing aid according to claim 1 or 2, in which different chronological sequences of the entry and/or exit of the hand (13) into the detection area or out of the detection area initiate different operating functions.

4. Hearing aid according to one of the claims 1 to 3, in which the operating function relates to the setting of the active hearing programme or to volume control.

5. Hearing aid according to one of the claims 1 to 4, in which the operating function is undertaken taking into account the distance of the hand (13) from the proximity sensor (6; 12A, 12B) and especially taking into account a change in this distance.

6. Hearing aid according to one of the claims 1 to 5, in which the detection area is restricted to a distance of between 0 and 10 cm from the proximity sensor (6; 12A, 12B).

7. Hearing aid according to one of the claims 1 to 6, in which the proximity sensor (6; 12A, 12B) is designed as an infrared proximity sensor, ultrasound proximity sensor, inductive proximity sensor or capacitive proximity sensor.

8. Hearing aid according to one of the claims 1 to 7, where the operating function is only initiated if, immediately after the entry of the hand (13) into the detection are of the proximity sensor (6; 12A, 12B) a control element (9) of the hearing aid (1) which can be activated by touching it directly with the hand, is not activated.

9. Hearing aid according to one of the claims 1 to 8, in which a number of proximity sensors (12A, 12B) with different detection areas relative to the hearing aid (11) are present.

10. Hearing aid according to one of the claims 1 to 9, embodied as a hearing aid that can be worn in the ear and especially as a hearing aid that can be worn completely within the auditory canal.

## Revendications

1. Prothèse (1; 11) auditive ayant un dispositif de commande, **caractérisé en ce que** le dispositif de commande comprend au moins un capteur (6, 12A, 12B) de proximité, qui, lors de l'entrée ou de la sortie d'une main (13)d'un porteur de la prothèse auditive dans la zone de détection ou hors de la zone de détection du capteur (6, 12A, 12B) de proximité, déclenche une fonction de commande.

2. Prothèse auditive suivant la revendication 1 dans laquelle seule une succession déterminée dans le temps d'une entrée et/ou d'une sortie de la main (13) se répétant plusieurs fois, dans la zone de détection ou hors de la zone détection déclenche la fonction de commande.

3. Prothèse auditive suivant la revendication 1 ou 2, dans laquelle des successions différentes dans le temps de l'entrée et/ ou de la sortie de la main (13) dans la zone de détection ou hors de la zone de détection déclenchent des fonctions de commande différentes.

4. Prothèse auditive suivant l'une des revendications 1 à 3, dans laquelle la fonction de commande concerne le réglage du programme auditif actif ou la régulation du haut-parleur.

5. Prothèse auditive suivant l'une des revendications 1 à 4, dans laquelle la fonction de commande s'effectue en tenant compte de la distance entre la main (13) et le capteur (6, 12A, 12B) de proximité et notamment en tenant compte d'une variation de cette distance.

6. Prothèse auditive suivant l'une des revendications 1 à 5, dans laquelle la zone de détection est limitée à une distance de 0 à 10 centimètres du capteur (6, 12A, 12B) de proximité.

7. Prothèse auditive suivant l'une des revendications 1à 6, dans laquelle le capteur (6, 12A, 12B) de proximité est réalisé sous la forme d'un capteur de proximité infrarouge, d'un capteur de proximité à ultrasons, d' un capteur de proximité inductif ou d' un capteur de proximité capacitif.

8. Prothèse auditive suivant l'une des revendications 1 à 7, dans laquelle la fonction de commande n est déclenchée que si un élément (9) de commande de la prothèse (1) auditive, qui peut être actionné à la main par un contact direct, n est pas actionné immédiatement après l'entrée de la main (13) dans la zone de détection du capteur (6, 12A, 12B) de proximité.

9. Prothèse auditive suivant l'une des revendications 1 à 8, dans laquelle il est prévu plusieurs capteurs (12A, 12B) de proximité ayant des zones de détection différentes par rapport à la prothèse (11) auditive.

10. Prothèse auditive suivant l'une des revendications 1 à 9, constituée sous la forme d'une prothèse auditive pouvant être portée à l'oreille ou/et notamment pouvant être portée dans le tuyau auditif.
